# EUROPEAN PATENT APPLICATION

(11) **EP 1 628 335 A1**
(43) Date of publication of application: **22.02.2006**
(21) Application number: 04745396.4
(22) Date of filing: 28.05.2004
(51) Int. Cl.: H01L 21/304, H01L 21/306, B08B 7/00, C23F 1/00

(54) **SURFACE TREATING METHOD USING ION BEAM AND SURFACE TREATING DEVICE**

(30) Priority: 28.05.2003 JP 2003151607
(71) Applicant: Kyoto University, Kyoto-shi, Kyoto 606-8501 (JP)
(72) Inventor: TAKAOKA, Gikan, (JP)
(74) Representative: Körfer, Thomas
(86) International application number: PCT/JP2004/007360
(87) International publication number: WO 2004/107425

(57) **Abstract**

The problems to be solved by the present invention are to provide a novel surface treatment method and a surface treatment apparatus for surface cleaning or surface processing of a solidmaterial, which utilizematerial that assumes a liquid state at normal temperature and pressure, and the surface treatment method according to the present invention as a solution to the problems is **characterized in that** ion beams formed by ionizing material which assumes a liquid state at normal temperature and pressure are radiated to the surface of a solid material. Further, the surface treatment apparatus according to the present invention is **characterized in that** the apparatus is equipped with a means for radiating ion beams formed by ionizing material which assumes a liquid state at normal temperature and pressure to the surface of a solid material.

## Description

### Technical Field of the Invention

The present invention relates to a novel surface treatment method and a surface treatment apparatus for surface cleaning or surface processing of a solidmaterial, which utilize material that assumes a liquid state at normal temperature and pressure.

### Background Art

Surface treatment method using ion beams has been known for long as a method for surface cleaning or surface processing of various types of solid materials such as a semiconductor substrate; however, those methods known in the art employ materials that assume a solid or gaseous state at normal temperature and pressure as the ion generating source material.

In such circumstances, for instance, in case surface cleaning is performed by irradiating the surface of the solid material with ion beams formed from monoatomic or monomolecular ions of materials that are gaseous at normal temperature and pressure, the incident energy of the ions incident to the surface of the solid material should be set as high as several kilo electron volts (keV) ; on the contrary, if the incident energy should be 100eV or lower, the ion current flowing into the solid material becomes extremely small. Accordingly, there has been a problem of making it unfeasible to obtain solid materials with clean surfaces due to too high incident energy, because there generated defects on the surface of the solid materials, or the ions implanted into the surface of the solid materials became impurity atoms. Furthermore, in case polyatomic molecular ion beams were radiated to the surface of a solid material under an incident energy as high as several kilo electron volts (keV), a problem has been found, such that the molecule dissociates on collision with the surface of the solid material; efficient surface cleaning which utilizes the molecular characteristics was no longer possible because the molecule itself lost the intrinsic characteristics.

As a means for overcoming the problems above, there has been proposed a surface treatment method using cluster ion beams formed by ionizing clusters, which are massive atomic groups or massive molecular groups; for instance, in patent reference 1 is disclosed a method for forming thin films on the surface of a solid material by utilizing gas cluster ion beams using material which is gaseous at normal temperature and pressure as the ion generating source material.

However, no reports have been made so far on surface treatment method employing ion beams utilizing material which assumes a liquid state at normal temperature and pressure as the ion generating source material. The application of ions of materials which assume a liquid state at normal temperature and pressure has been extremely limited to the mass analysis of trace components and the like, and in such applications, the ion current flowing into the target was so small that there was no need of forming ions into a beam. Accordingly, so long as it is an extension of such application, surface treatment of a solid material is unfeasible by using the ions of material which assumes a liquid state at normal temperature and pressure.

Wet processes for cleaning or etching the surface of a solid material by using material which assumes a liquid state at normal temperature and pressure are well known in the art. For instance, alcoholic solutions and the like are used for cleaning the surface to remove oils and fats, dust, and so forth. Furthermore, an acidic solution is used in case of removing oxides that are present on the surface of a solid material. However, in the latter method, acidic solution residues on the surface of the solid material lead to corrosion and the like of the solid material; hence, it is necessary to remove the residual acidic solution, and this makes the treatment complicated because it requires an additional operation such as cleaning the surface of the solid material by using pure water. Furthermore, in either case, it can be hardly said that the cleaned surface of the solid material has superior stability in chemical properties. Accordingly, in spite of the long-time consuming cleaning, the resulting surface suffers problems of re-contamination due to oxygen, dust, and the like, which are adsorbed to the surface from the ambient.

Patent Reference 1: JP-A-2003-13208.

### Disclosure of the Invention

### Problems the Invention is to Solve

Accordingly, an objective of the present invention is to provide a novel surface treatment method and a surface treatment apparatus for surface cleaning or surface processing of a solidmaterial, which utilize material that assumes a liquid state at normal temperature and pressure.

### Means for Solving the Problems

The surface treatment method according to the present invention accomplished in the light of the aforementioned circumstances is as described in claim 1, and is characterized in that ion beams formed by ionizing material which assumes a liquid state at normal temperature and pressure are radiated to the surface of a solid material.

Further, the surface treatment method as described in claim 2 is as disclosed in claim 1, characterized in that the incident energy of the ions incident to the surface of the solid material is controlled.

Furthermore, the surface treatment method as described in claim 3 is as disclosed in claim 1, characterized in that the ion beams are cluster ion beams formed by ionizing clusters, which are massive molecular groups of material that assumes a liquid state at normal temperature and pressure.

Additionally, the surface treatment method as described in claim 4 is as disclosed in claim 3, characterized in that cluster ion beams, which is constituted by molecules the number of which is selected by mass separation, are radiated to the surface of the solid material by applying an acceleration voltage.

Moreover, the surface treatment method as described in claim 5 is as disclosed in claim 1, characterized in that the material which assumes a liquid state at normal temperature and pressure is alcohol or acetone.

Further, the surface treatment apparatus according to the present invention is as described in claim 6, characterized in that the apparatus is equipped with a means for radiating ion beams formed by ionizing material which assumes a liquid state at normal temperature and pressure to the surface of a solid material.

Furthermore, the surface treatment apparatus as described in claim 7 is as disclosed in claim 6, characterized in that the solid material is attached to the inside of a Faraday cup having a configuration capable of accurately measuring the ion current flowing into the solid material.

Additionally, the surface treatment apparatus as described in claim 8 is as disclosed in claim 6, characterized in that the ion beams are cluster ion beams formed by ionizing clusters, which are massive molecular groups of material that assumes a liquid state at normal temperature and pressure.

Further, the surface treatment apparatus as described in claim 9 is as disclosed in claim 8, characterized in that the material that assumes a liquid state at normal temperature and pressure is ejected into vacuum through a small opening, such that the cluster may be generated by adiabatic expansion.

Further, the surface treatment apparatus as described in claim 10 is as disclosed in claim 9, characterized in that the small opening is provided in the shape of a nozzle.

Further, the surface treatment apparatus as described in claim 11 is as disclosed in claim 8, characterized in that the cluster thus generated is ionized by electron impact.

Further, the surface treatment apparatus as described in claim 12 is as disclosed in claim 8, characterized in that the number of the constituting molecules of the cluster ion beams is selected by mass separation based on retardation field method.

Moreover, the surface treatment apparatus as described in claim 13 is as disclosed in claim 6, characterized in that the incident energy of the ions incident to the surface of the solid material is controlled.

### Effect of the Invention

The present invention provides a novel surface treatment method and a surface treatment apparatus for surface cleaning or surf ace process ing of a solid material, which utilize material that assumes a liquid state at normal temperature and pressure.

### Brief Description of the Drawings

FIG. 1 is a schematic diagram showing a surface treatment apparatus according to the Example;
FIG. 2 shows an enlarged view of the liquid source of the surface treatment apparatus according to the Example;
FIG. 3 is a diagram showing the constitution of the electrodes of the surface treatment apparatus according to the Example;
FIG. 4 is a schematic diagram of the Faraday cup for the surface treatment apparatus according to the Example;
FIG. 5 is a graph showing the beam current characteristics of an ethanol cluster ion beam with respect to the retardation voltage according to the Example;
FIG. 6 is a graph showing the size distribution of the ethanol cluster ions according to the Example;
FIG. 7 is a graph showing the beam shape of the ethanol cluster ions according to the Example;
FIG. 8 is a graph showing the dependence of etching depth on the accelerating voltage for a silicon substrate and a silicon oxide film irradiated with the ethanol cluster ions according to the Example;
FIG. 9 is a photograph showing an AFM image of the surface of the silicon oxide film irradiated with the ethanol cluster ions according to the Example;
FIGS. 10(a) and 10(b) are each photographs showing AFM images of the surface of the silicon substrate irradiated with the ethanol cluster ions, and the surface of a non-irradiated silicon substrate, respectively, according to the Example;
FIG. 11 is a graph showing channeling spectral obtained by RBS method for a silicon substrate irradiated with the ethanol cluster ions according to the Example (No. 1);
FIG. 12 is a graph showing channeling spectral obtained by RBS method for a silicon substrate irradiated with the ethanol cluster ions according to the Example (No. 2); and
FIG. 13 is a graph showing the dependence of the contact angle on the irradiation dose for a silicon substrate irradiated with the ethanol cluster ions according to the Example.

### Explanation of Symbols

- 1: Source chamber
- 2: Differential exhaust chamber
- 3: Target chamber
- 4: Liquid source
- 5: Fine tube
- 6: Support table
- 7: Inspection window
- 8: Heater
- 9: Nozzle
- 10: Skimmer
- 11: Mechanical booster pump
- 12: Oil rotary pump
- 13: Oil diffusion pump
- 14: Oil rotary pump
- 15: Aperture
- 16: Ionization part
- 17: Mass separator
- 18: Faraday cup
- 19: Oil diffusion pump
- 20: Throat portion
- 21: Filament
- 22: Anode electrode
- 23: Extraction electrode
- 24: Acceleration electrode
- 25: Retardation electrode
- 26: Electrode
- 27: Ion current detection plate
- 28: Valve
- 30: Substrate
- 31: Substrate holder
- 32: Current meter
- 33: First cylindrical case
- 34: Current meter
- 35: Second cylindrical case
- 36: Beam control plate

### Best Mode for Carrying Out the Invention

The surface treatment method according to the present invention is characterized in that ion beams formed by ionizing material which assumes a liquid state at normal temperature and pressure (hereafter sometimes referred to simply as liquid or liquid material) are radiated to the surface of a solid material. Materials which assume a liquid state at normal temperature and pressure include materials having various types of structures or chemical properties, such as liquid organic compounds. In the surface treatment method according to the present invention, by selecting, among these materials, material suitable for use as the ion generating source material for the surface treatment of the target solid material (for instance, in case of performing surface etching of the solid material, i.e., when it is desired that the liquid etchant is finally removed from the surface of the solid material, a highly volatile liquid is selected; in case it is desirous that the liquid is adsorbed or adhered to the surface of the solid material, a liquid to be adsorbed or adhered is selected), it is possible to perform surface treatment which have been unfeasible or difficult to realize by a known surface treatment method using materials which assume a solid or gaseous state at normal temperature and pressure as the ion generating source material.

For instance, the surface treatment method according to the present invention enables control of the surface of the solid material, such as the hydrophilic or hydrophobic properties, lubricating properties, and the like, or enables surface modification by addition or substitution reaction. Furthermore, it is possible to impart characteristics specific to liquid, such as fluidity, to the surface of the solidmaterial. In case of performing such a surface treatment, it is necessary that the ions are adsorbed or adhered to the surface of the solid material by controlling the incident energy of the ions incident to the surface of the solid material as low as several tens of electron volts or even lower; the surface treatment of the surface of the solid material by adsorption or adhesion of ions can be implemented by utilizing cluster ion beams formed by ionizing clusters that are massive molecular groups of the liquid. By using the cluster ion beams, it is possible to control the energy possessed by the cluster ions, and at the same time, perform surface treatment at a higher total energy, while suppressing the incident energy per ion of one molecule low as compared with the case using ion beams formed by monomolecular ions.

Further, the incident energy per ion of one molecule can be controlled by adjusting the number of molecules constituting the cluster ion beams. Thus, surface treatment of a wide variety of solid material is made possible as the degree of freedom in controlling the incident energy of the ions incident to the surface of the solid material increases (for instance, the incident energy can be freely controlled depending on the objectives, such as lowering the incident energy in case ions are adsorbed or adhered to the surface of the solid material, and increasing the incident energy in case of performing etching the surface of the solid material with ions) together with high degree of freedom in selecting the liquid for use as the ion generating source material. This therefore enables formation of a flawless surface free from defects to the surface of the solid material, or an ultra-flat surface by controlling the fluidity characteristic of liquid or the incident energy of ions. Furthermore, since the clusters that are formed of the constituting molecules with uniform number are microscopically uniform, they may exhibit properties different from their liquid state at normal temperature and pressure. Accordingly, based on the microscopic uniformity, it is expected to obtain a result different from the surface treatment results accumulated by wet processes, or a possibility of realizing surface treatment unfeasible by wet processes.

Examples of the material which assumes a liquid state at normal temperature and pressure include alcohols (such as methanol, ethanol, and the like) and acetone. The liquid used as the ion generating source material generates clusters by adiabatic expansion, for instance, by ejecting the liquid into vacuum through a small opening. The small opening for ejecting the liquid into vacuum may have, for instance, a nozzle shape with a tapered point and a broadened end, such that the liquid in highly pressurized vapor phase can be ejected into vacuum. The cluster thus generated is formed into a beam-like shape, and then ionized by electron impact to produce a cluster ion beam. Then, the number of the constitutingmolecules is selected, for example, by mass separation based on retardation field method, to obtain cluster ion beams made from the desired cluster size, which is then accelerated and radiated to the surface of the solid material. Preferably, from the viewpoint of usability of molecules, the number of molecules constituting the cluster ion beams is several hundreds or less.

Furthermore, in addition to the method utilizing electron impact, a method using laser beam irradiation may be used as a method for ionizing clusters. Moreover, as a method for mass separation of cluster ion beams, methods other than retardation field method may be used, such as mass separation using sector type electromagnets, mass separation using orthogonal electromagnetic fields, mass separation using quadrupole radio frequency electric field, and the like.

In the surface treatment method according to the present invention, the solid materials that are irradiated with the ion beams formed by ionizing material which assumes a liquid state at normal temperature and pressure are not only limited to substrates made of a semiconductor or an insulator, but also may be substrates of metal, organic material, and the like; furthermore, they are not only limited to substrates, but also may be thin films, minute cubes or polyhedrons, and are not limited by size or shapes. Hence, the surface treatment method according to the present invention is applicable to the surface treatment of various types of articles, including electronic components, optical components, mechanical parts, and the like.

Furthermore, in case the surface treatment method according to the present invention utilizes cluster ion beams formed by ionizing clusters, which are massive molecular groups of material that assumes a liquid state at normal temperature and pressure, it is possible to clarify various types of solvent-solute reaction in atomic level by focusing on the phenomena in which the chemical reactions differ depending on the number of the constituting molecules (cluster size) or the cluster structure of the cluster ion beams.

### Examples

The present invention is explained in further detail below by means of examples referring to drawings, but it should be understood that the present invention is not limited to the description below.

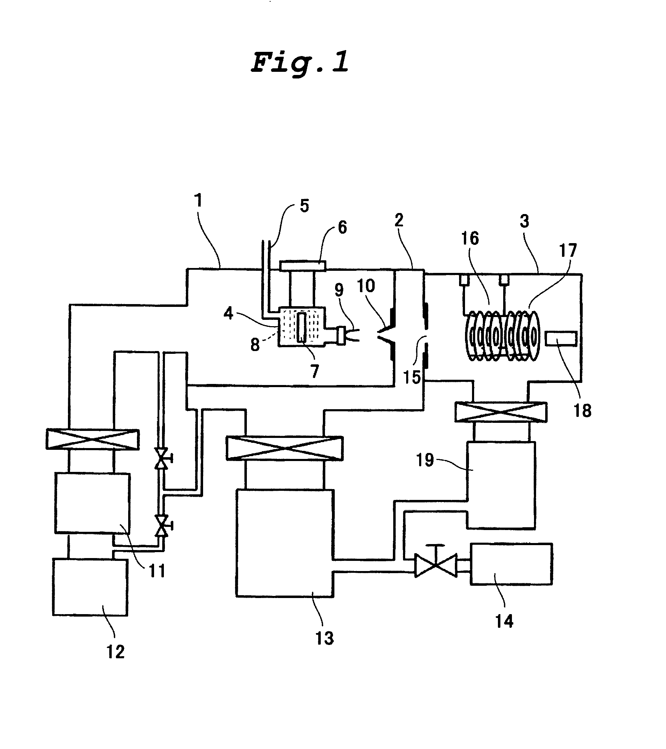

Figure 1 is a schematic diagram showing an example of a surface treatment apparatus, in which a high-pressure vapor of material such as alcohol and acetone, that assumes a liquid state at normal temperature and pressure is ejected through a small opening of a nozzle shape into vacuum, such that the clusters, which are massive molecular groups, may be generated by adiabatic expansion; the clusters thus generated are ionized by electron impact; the extracted cluster ion beams are transported after selecting the number of the constituting molecules by mass separation based on retardation field method, and are radiated to the surface of the substrate. The surface treatment apparatus has a basic configuration consisting of a source chamber 1 which is a vacuum vessel for generating a cluster of material that assumes a liquid state at normal temperature and pressure, a differential exhaust chamber 2 which is a vacuum vessel for allowing the cluster generated in the source chamber 1 to pass through a skimmer 10 having a small opening so as to make the cluster into a thin beam-like shape, and a target chamber 3 which is a vacuum vessel for ionizing the thus formed cluster beam and irradiating the surface of the substrate with a cluster ion beam having the constituting molecules the number of which is selected by mass separation. A liquid source 4 provided to the source chamber 1 is made of stainless steel, which is 10 cm in width, 5 cm in length, and 8 cm in height. The liquid material for use as the ion generating source material is supplied through a fine tube 5 connected to one end of the liquid source 4. The liquid source 4 is mounted on a support table 6 that is independently movable in three axial directions, i.e., along the X-axis which is extended in the left and right directions, Y-axis which is extended in the upper and lower directions, and Z-axis which is extended in the direction of beam propagation; by using a micrometer, said table is movable within a range of ±5 mm along the X-axis, ±10 mm along the Y-axis, and ±5 mm along the Z-axis. The amount of the liquid material supplied to the liquid source 4 is observable from an inspection window 7 provided to one side of the liquid source 4. Continuous supply and control of the supply amount can be easily realized because a liquid material is used as the ion generating source material. Furthermore, the internal temperature of the liquid source 4 can be controlled by supplying electric current to a heater 8 wound around the periphery of the liquid source 4; for instance, it can be heated to 200 °C. The vapor thus generated from the heated liquid material is ejected into vacuum through a small opening provided to a nozzle 9 having a tapered point and a broadened end, which is connected to one end of the liquid source 4. At this time, the clusters, which are massive molecular groups, are generated by adiabatic expansion. The clusters thus generated are formed into a thin beam-like shape on passing through a skimmer 10, which is conical in shape and has an opening 0.5 mm in diameter, and are introduced into the differential exhaust chamber 2. The vacuum evacuation of the source chamber 1 is carried out by operating a mechanical booster pump 11 and an oil rotary pump 12, where the vacuum degree before ejecting the liquid material in vapor phase is 3 × 10⁻³ Torr. The vacuum evacuation of the differential exhaust chamber 2 is carried out by operating an oil diffusion pump 13 and an oil rotary pump 14, where the vacuum degree before introducing the liquid material in vapor phase is 6 × 10⁻⁷ Torr.

An aperture 15 having an opening 3 mm in diameter is provided between two vacuum vessels, the differential exhaust chamber 2 and the target chamber 3. The cluster beam introduced from the source chamber 1 to the differential exhaust chamber 2 passes through the aperture 15 and is introduced into an ionization part 16 provided in the target chamber 3. The cluster beam introduced into the ionization part 16 is ionized by electron impact. The cluster ion beam extracted from the ionization part 16 is introduced into a mass separator 17, where the number of the constituting molecules thereof is selected by mass separation based on retardation field method, and the cluster ion beam runs through the vacuum inside the target chamber 3, is introduced into a Faraday cup 18, and is radiated to the surface of the substrate attached to the inside of the Faraday cup 18. The vacuum evacuation of the target chamber 3 is carried out by operating an oil diffusion pump 19 and an oil rotary pump 14, where the vacuum degree before introducing the cluster is 6 × 10⁻⁷ Torr.

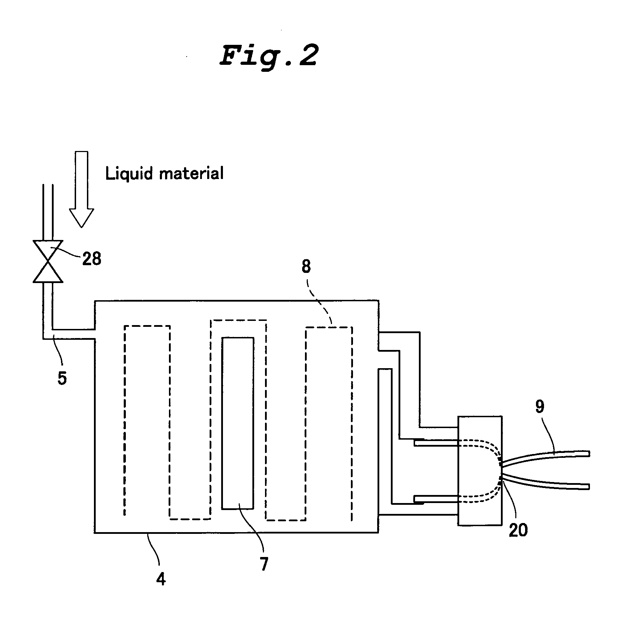

Figure 2 shows an enlarged view of the liquid source 4. The liquid material is introduced into the liquid source 4 through the fine tube 5, and a valve 28 is shut after visually confirming by observation through the inspection window 7 that the predetermined amount is introduced. Furthermore, the liquid source 4 is heated by supplying electric current to the heater 8 wound around the periphery of the liquid source 4. The vapor of the thus heated liquid material is ejected into vacuum through the small opening provided in a throat portion 20 of the nozzle 9 having a tapered point and a broadened end, which is connected to one end of the liquid source 4. The diameter of the small opening is 0.1 mm.

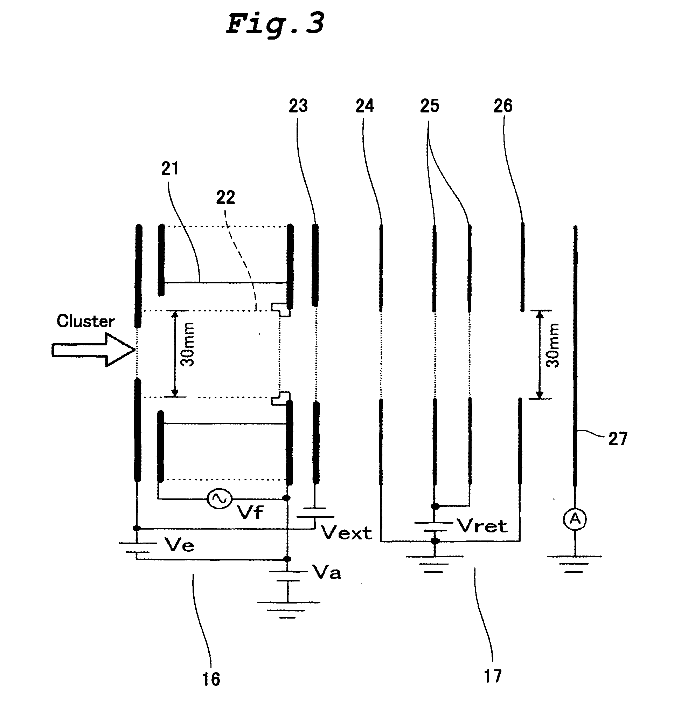

Figure 3 is a diagram showing the constitution of the electrodes of the ionization part 16 and the mass separator 17. The ionization part 16 is constructed by a filament 21 which emits electrons for use in the ionization, and an anode electrode 22 made of a stainless steel mesh. The anode electrode 22 has an opening 30 mm in diameter. The filament 21 is made of tungsten wires 0.3 mm in diameter. On flowing electric current by applying an alternating current voltage (Vf) to the filament 21, electrons are emitted from the filament 21 heated to high temperatures. The electrons emitted from the filament 21 are accelerated by a maximum voltage (Ve) of 300 V applied between the filament 21 and the anode electrode 22, and are captured by the anode electrode 22. The electrons passed through the mesh interstices of the anode electrode 22 collide with the cluster beam introduced into the ionization part 16, and ionize the clusters constituting the beam. The cluster ions thus generated are extracted by applying a maximum voltage (Vext) of 2 kV to the anode electrode 22 with respect to an extraction electrode 23. Thus extracted cluster ions are accelerated by applying a maximum voltage (Va) of 10 kV to the anode electrode 22 with respect to the ground potential.

The accelerated cluster ion beam passes through an acceleration electrode 24 held at the ground potential, and is incident into a retardation electrodes 25 provided as parallel plates. At this instance, mass separation of the cluster ions, i. e. , size separation, can be carried out by applying a positive retardation voltage (Vret) to the retardation electrode 25 with respect to the acceleration electrode 24. After the mass separation, the cluster ion beam passes through an electrode 26 connected at the same potential as the acceleration electrode 24, and is introduced into the Faraday cup, so that it is radiated to the surface of the substrate attached to the inside of the Faraday cup. Here, Fig. 3 shows a case in which an ion current detection plate 27, which is used for measuring the current of cluster ion beam, is assembled in place of the Faraday cup having a substrate attached therein. Further, since the retardation voltage for the cluster ion beam corresponds to the difference in voltage between the voltage applied to the anode electrode 22 and the voltage applied to the retardation electrode 25, it is represented by retardation voltage (Vr) to be distinguished from the retardation voltage (Vret) applied to the retardation electrode 25.

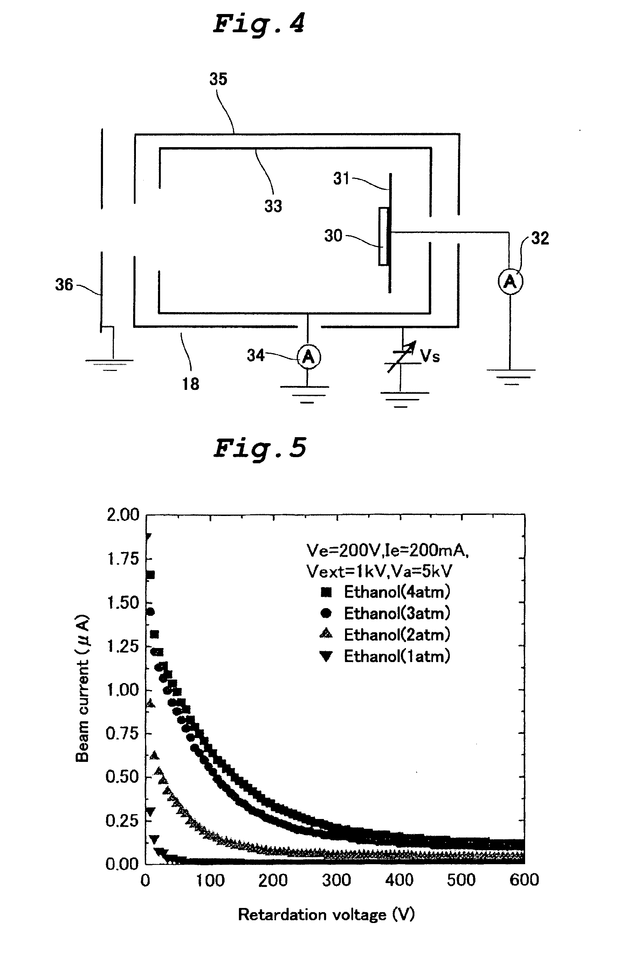

Figure 4 is a schematic diagram of the Faraday cup 18. The Faraday cup 18 is made of a cylindrical stainless steel plate, and a substrate holder 31 is provided to the inside of the Faraday cup 18 , so that a substrate 30 may be attached thereto. The substrate holder 31 is connected to a current meter 32 by a shielded copper wire, so that the apparent electric current value of the ion current flowing into the substrate can be measured by the current meter 32. Furthermore, secondary electrons emitted from the substrate upon ion beam irradiation flow into a first cylindrical case 33 which constitutes the inner side of the Faraday cup 18. The current of the secondary electrons flowing into the first cylindrical case 33 can be measured by a current meter 34 connected to the first cylindrical case 33. Furthermore, by applying a negative voltage (Vs) with respect to the first cylindrical case 33 to a second cylindrical case 35 that is assembled on the outer side of the first cylindrical case 33, it is possible to suppress secondary electrons flowing out of the Faraday cup 18 through the openings of the first cylindrical case 33. Moreover, a beam control plate 36 is provided to the front side of the second cylindrical case 35, so that the cluster ion beam flowing into the Faraday cup 18 should not collide with the second cylindrical case 35. The ion current flowing into the substrate can be measured accurately from the observed current values on the current meter 32 and the current meter 34.

Then, an experiment was performed by using ethanol as the material which assumes a liquid state at normal temperature and pressure and the surface treatment apparatus shown in Fig. 1; cluster was generated by ejecting vapor of ethanol through the nozzle, which was made into a thin beam-like shape and ionized by electron impact, and the extracted ion beam was subjected to mass separation and radiated to the surfaces of a silicon substrate or a silicon oxide film. The experimental results are described based on Figs. 5 to 13.

Figure 5 is graph showing the beam current characteristics of the extracted cluster ion beam after ionizing the generated ethanol clusters with respect to the retardation voltage. Here, the data are taken while changing the vapor pressure of ethanol in the range of 1 to 4 atm under ionization electron voltage (Ve) = 200 V, ionization electron current (Ie) = 200 mA, ion extract voltage (Vext) = 1 kV, and acceleration voltage (Va) = 5 kV. From Fig. 5, it can be understood that the beam current decreases with increasing retardation voltage. Furthermore, it is shown that the beam current increases with increasing vapor pressure of ethanol. From such characteristics, cluster size distribution characteristics can be obtained from the ratio of the increment in beam current with respect to the increment in retardation voltage. That is, because the energy per one ethanol molecule can be calculated from the temperature of the liquid source and the specific heat capacity ratio of ethanol, the number of molecules per one cluster, i.e., the cluster size (the number of molecules constituting the cluster ion beam), can be calculated by dividing the retardation voltage with the energy per one ethanol molecule. As a result, the energy per one ethanol molecule had been calculated from the experiment above to be 0.284 eV.

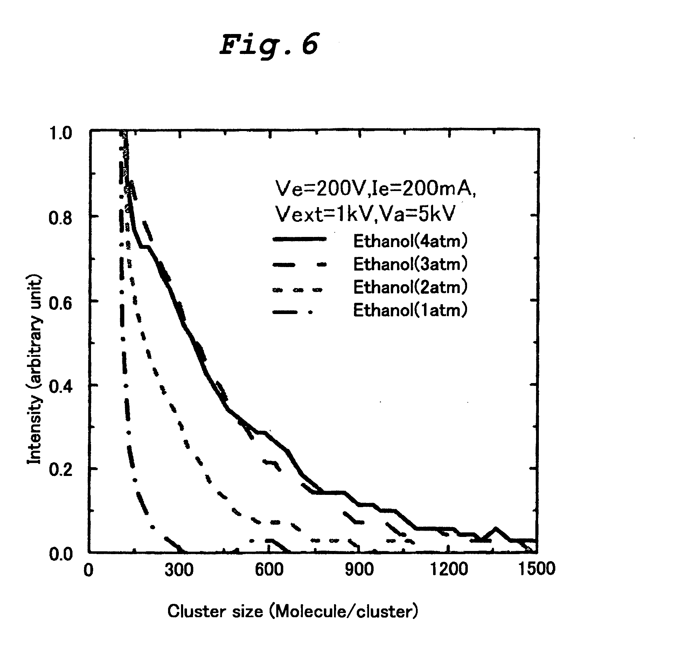

Figure 6 is a graph showing the size distribution of the thus generated ethanol cluster ions. Figure 6 reads that the amount of cluster generated increases with increasing vapor pressure of ethanol, and that clusters whose cluster size is distributed in a range of several hundreds to thousand and several hundreds are obtained (the intensity plotted along the ordinate shows the relative percentage of clusters with sizes of 120 molecules or more with respect to the entire number of clusters).

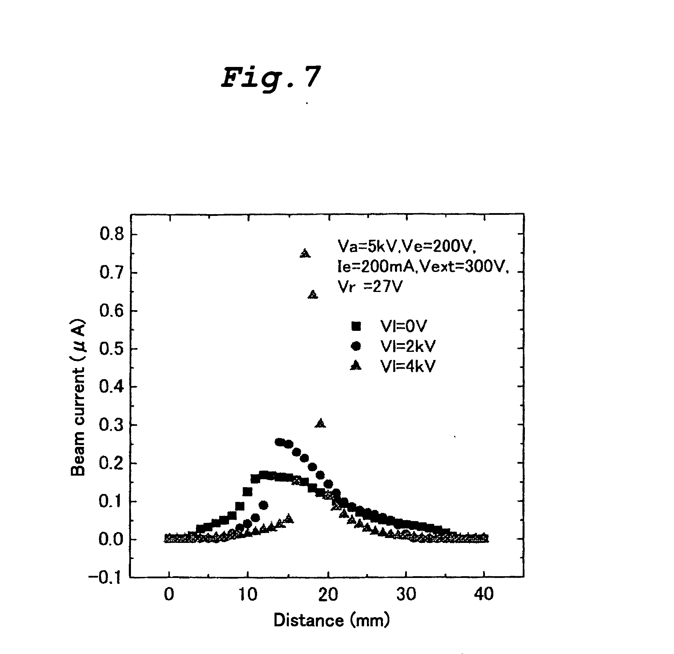

Figure 7 is a graph showing the beam shape of the generated ethanol cluster ions. Here, the data are taken by isolating ethanol cluster ions 95 or larger in size by applying a retardation voltage (Vr) of 27 V under ionization electron voltage (Ve) = 200 V, ionization electron current (Ie) = 200 mA, ion extract voltage (Vext) = 300 V, and acceleration voltage (Va) = 5 kV; furthermore, the beam shape was controlled by the lens voltage (VI) applied to the einzel lens. Figure 7 reads that the ion current at the central axis of the beam disposed at a distance of approximately 15 mm from the center of the measurement system is obtained in a range of 0.2 to 0.75 µA by controlling the lens voltage. Accordingly, it can be understood that several tens of microamperes or higher electric current is obtained, because the amount of equivalent electric current is obtained by multiplying the value of electric current by the cluster size. Furthermore, it turned out from the half bandwidth of the beam shape of the cluster ions shown in the graph that there were obtained fine beams with several millimeters to ten and several millimeters in diameter.

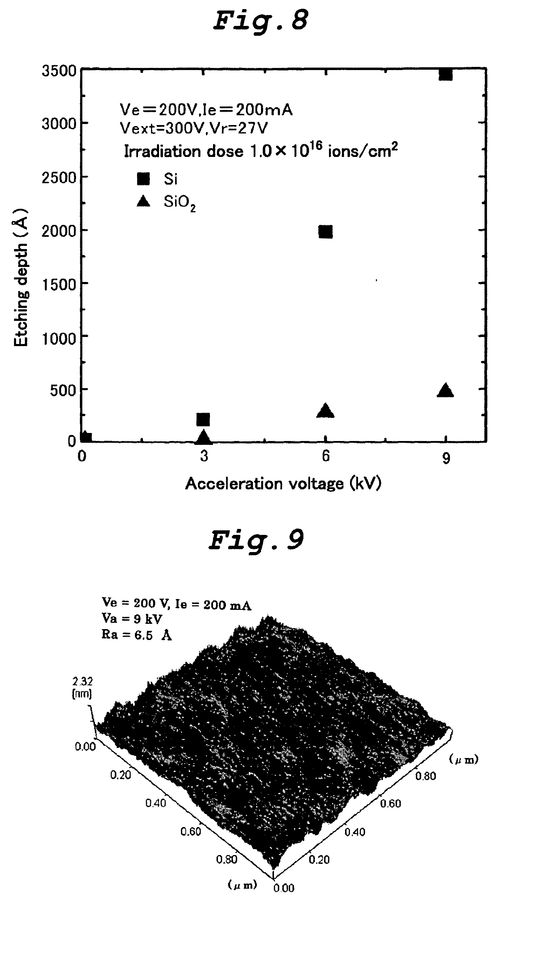

Figure 8 is a graph obtained by measuring the etching depth of a silicon (Si) substrate and a silicon oxide (SiO₂) film after irradiating the surface of the silicon substrate and the surface of a silicon oxide film with the cluster ions composed of the generated ethanol clusters 95 or larger in size, while changing the accelerating voltage (Va). 1 × 10¹⁶ cluster ions were irradiated per unit area of 1 cm². From Fig. 8, it is understood that the silicon oxide film remains non-etched up to an acceleration voltage of 3 kV. However, the etching depth increases with increasing acceleration voltage, and it turned out that the etching depth was 284 Å at an acceleration voltage of 6 kV and 472 Å at an acceleration voltage of 9 kV.

Figure 9 is a photograph showing an atomic force microscope (AFM) image of the surface of the silicon oxide film subjected to etching under an acceleration voltage of 9 kV. Figure 9 reads that the surface of the silicon oxide film is flat in atomic level, and that the surface roughness (Ra) is 6.5 Å. Accordingly, it is understood that the silicon oxide film is etched by irradiating its surface with accelerated ethanol cluster ions, and that an ultra-flat surface in nanometer order is obtained by utilizing the fluidity characteristic of liquid and the acceleration energy of ions.

Concerning silicon substrate, on the other hand, Fig. 8 shows that the etching depth quickly increases with increasing acceleration voltage, and that it reaches an etching depth of 3446 Å at an acceleration voltage of 9 kV. On calculating the etching ratio based on the results with the density of silicon substrate taken into consideration as 2.42 g/cm³, a value of 176 atoms/ion is obtained; this etching ratio is 100 times or more higher than the etching ratio obtained by etching using ion beams formed of monoatomic argon ions. Furthermore, the etching ratio for the silicon substrate is 7 times or more higher than that for the silicon oxide film, suggesting that chemical etching attributed to ethanol cluster ions preferentially took place. Such high-speed etching has been unfeasible by any known wet processes using ultrasonic cleaning. Silicon substrate cannot be etched even if the etching should be performed by known wet processes using ultrasonic cleaning under conditions as such to irradiate the silicon substrate with 1×10¹⁹ ethanol molecules per unit area or more.

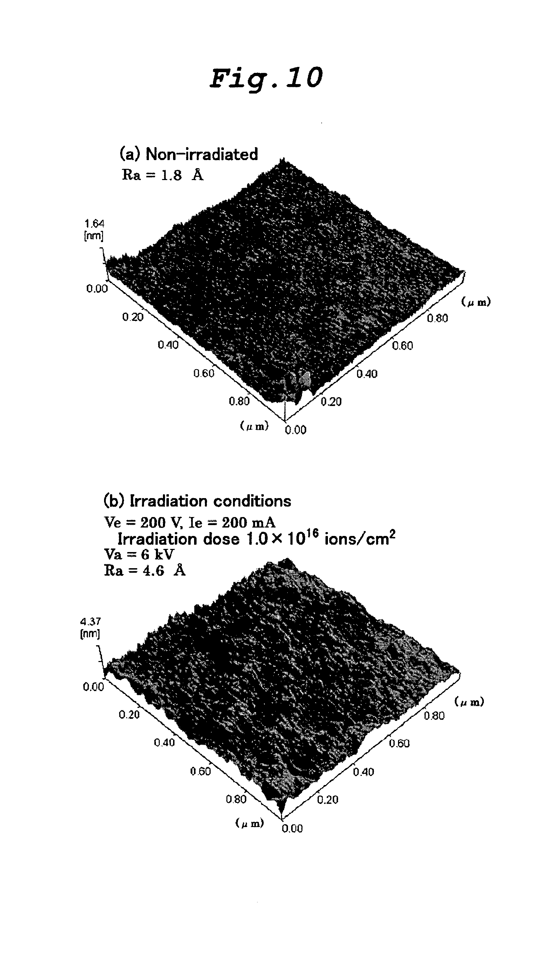

Figure 10 is a photograph showing an atomic force microscope (AFM) image of the surface of the silicon substrate after being subjected to irradiation with 1x10¹⁶ cluster ions per unit area. For comparative means, an AFM image of the surface of a non-irradiated silicon substrate is also shown. Figure 10 reads that the surface of the silicon substrate is flat in atomic level, and that the surface roughness (Ra) is 1.8 Å for the non-irradiated silicon substrate and 4.6 Å for the ion-irradiated silicon substrate. Accordingly, it is understood that the silicon substrate is etched by irradiating its surface with accelerated ethanol cluster ions, and that an ultra-flat surface in nanometer order is obtained by utilizing the fluidity characteristic of liquid and the acceleration energy of ions.

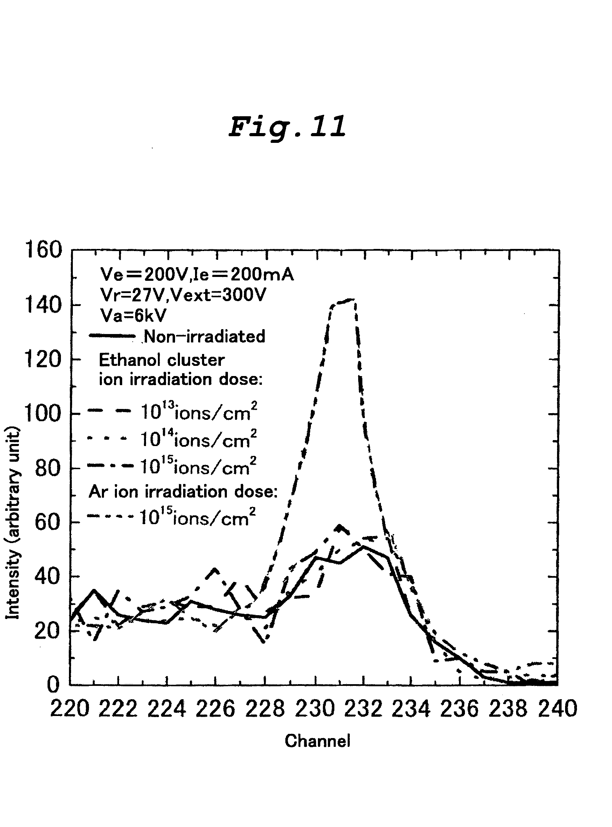

Figure 11 is a graph obtained by measuring the degree of irradiation damage of a silicon substrate by Rutherford back scattering (RBS) method (the intensity plotted along the ordinate is a relative value showing the degree of damage); i.e., the surface of a silicon substrate covered with a 6 nm thick silicon oxide film was irradiated with the cluster ions composed of the generated ethanol clusters 95 or larger in size; the silicon oxide film was removed with hydrofluoric acid after taking out the silicon substrate from the vacuum vessel; and the silicon substrate was subjected to the measurement. In this experiment, 1×10¹³ - 1×10¹⁵ cluster ions were irradiated per unit area of 1 cm² under an acceleration voltage of 6 kV. For comparative means, measured results are also shown for a case in which monoatomic ions of argon (Ar), whose mass number is about the same as that of ethanol molecule, were irradiated at a dose of 1×10¹⁵ ions per unit area under an acceleration voltage of 6 kV. Figure 11 shows that the damage peak area in the vicinity of 231 channel for the silicon substrate irradiated with ethanol cluster ions is about the same as that for the silicon substrate not irradiated with ions. However, the irradiation damage peak area for the substrate irradiated with Ar ions is larger by about three times as compared with that for the non-irradiated substrate. From these results, it is found that the ethanol cluster ions are dissociated into individual molecules upon incidence into the surface of the silicon substrate, and that the incident energy of the ions is distributed to each molecule and then implanted into the silicon substrate; thus, the damage due to ion irradiation is minimized. Hence, the incident energy per one molecule becomes equal to the incident energy of the ethanol cluster ions divided by the cluster size; i.e., incident energy with several kilo electron volts (keV) is reduced to lower energy with several tens of electron volts or lower, and this allows formation of a damage-free surface by controlling the acceleration voltage.

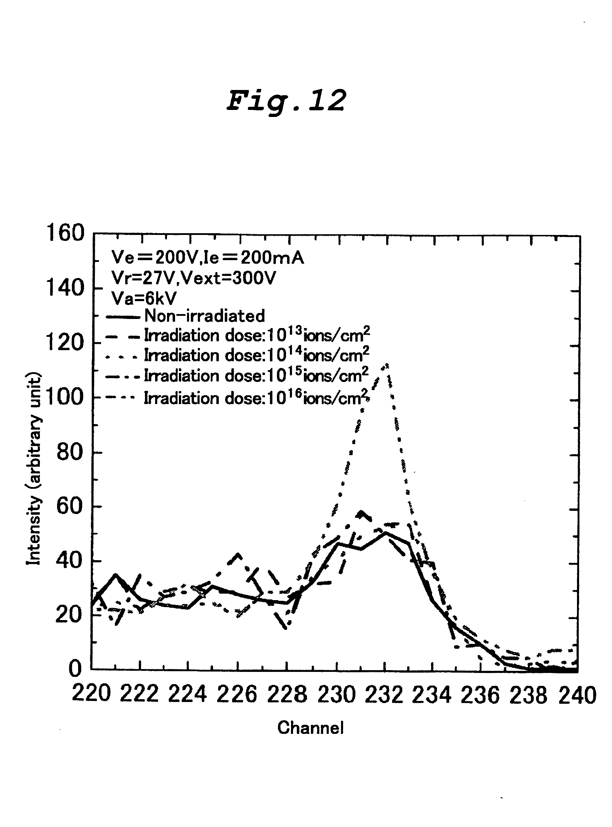

Figure 12 is a graph obtained by measuring the degree of irradiation damage of a silicon substrate by Rutherford back scattering (RBS) method (the intensity plotted along the ordinate is a relative value showing the degree of damage); i.e., the surface of a silicon substrate covered with a 6 nm thick silicon oxide film was irradiated with the cluster ions composed of the generated ethanol clusters 95 or larger in size; the silicon oxide film was removed with hydrofluoric acid after taking out the silicon substrate from the vacuum vessel; and the silicon substrate was subjected to the measurement. In this experiment, 1×10¹³ - 1×10¹⁶ cluster ions were irradiated per unit area of 1 cm² under an acceleration voltage of 6 kV. Figure 12 shows that the damage peak area in the vicinity of 231 channel for the silicon substrate irradiated with ethanol cluster ions at a dose of 1×10¹³ - 1×10¹⁵ cluster ions per unit area is about the same as that for the silicon substrate not irradiated with ions. From these results, it is found that the ethanol cluster ions are dissociated into individual molecules upon incidence into the surface of the silicon substrate, and that the incident energy of the ions is distributed to each molecule and then implanted into the silicon substrate; thus, the damage due to ion irradiation is minimized. On the contrary, it is found that the damage peak area increases in case irradiations are made at a dose of 1x10¹⁶ cluster ions per unit area. The results show that the 6 nm thick silicon oxide film on the silicon substrate is etched by the ethanol cluster ion irradiation, and that the base silicon substrate is etched to increase the damage peak.

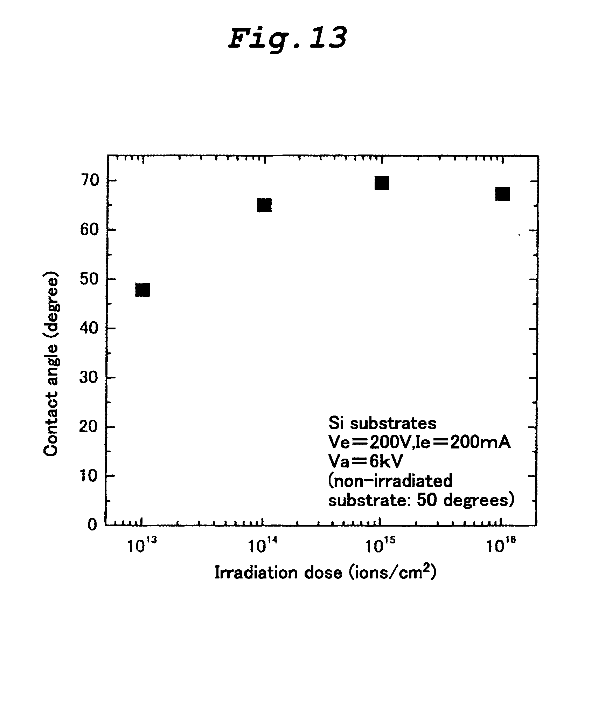

Figure 13 is a graph obtained by measuring the contact angle of a water droplet dropped on the surface of silicon substrates which have been irradiated with the cluster ions composed of the generated ethanol clusters 95 or larger in size at different ion doses, and which were then taken out from the vacuum vessel. The silicon substrates were irradiated with 1×10¹³ - 1×10¹⁶ cluster ions per unit area of 1 cm² under an acceleration voltage (Va) of 6 kV. Figure 13 shows that the contact angle for a non-irradiated silicon substrate is 50 degrees, and that the contact angle increases with increasing ion dose by irradiating ethanol cluster ions to yield a value of 65 to 70 degrees. The results show that the surface of the silicon substrate is modified by ethanol molecules upon irradiation of ethanol cluster ions, and that the alkyl groups constituting the ethanol molecules align on the outermost surface to thereby make the surface hydrophobic.

The experiments above clearly show that the surface treatment method according to the present invention is applicable for surface cleaning of substrates by removing the impurities such as oxides and the like that are present on the surface of the substrate. Furthermore, the surface modification of substrates may be such introducing reactive gases such as oxygen, nitrogen, and the like, in the periphery of the substrate, and by then irradiating cluster ion beams for accelerating substitution reaction, addition reaction, and the like, of the reactive gases.

### Industrial Applicability

The present invention possesses industrial applicability from the viewpoint that it provides a novel surface treatment method and a surface treatment apparatus for surface cleaning or surface processing of a solidmaterial, which utilize material that assumes a liquid state at normal temperature and pressure.

## Claims

1. A surface treatment method **characterized in that** ion beams formed by ionizing material which assumes a liquid state at normal temperature and pressure are radiated to the surface of a solid material.

2. The surface treatment method as claimed in claim 1, **characterized in that** the incident energy of the ions incident to the surface of the solid material is controlled.

3. The surface treatment method as claimed in claim 1, **characterized in that** the ion beams are cluster ion beams formed by ionizing clusters, which are massive molecular groups of material that assumes a liquid state at normal temperature and pressure.

4. The surface treatment method as claimed in claim 3, **characterized in that** cluster ion beams, which is constituted by molecules the number of which is selected by mass separation, are radiated to the surface of the solid material by applying an acceleration voltage.

5. The surface treatment method as claimed in claim 1, **characterized in that** the material which assumes a liquid state at normal temperature and pressure is alcohol or acetone.

6. A surface treatment apparatus **characterized in that** the apparatus is equipped with a means for radiating ion beams formed by ionizing material which assumes a liquid state at normal temperature and pressure to the surface of a solid material.

7. The surface treatment apparatus as claimed in claim 6, **characterized in that** the solid material is attached to the inside of a Faraday cup having a configuration capable of accurately measuring the ion current flowing into the solid material.

8. The surface treatment apparatus as claimed in claim 6, **characterized in that** the ion beams are cluster ion beams formed by ionizing clusters, which are massive molecular groups of material that assumes a liquid state at normal temperature and pressure.

9. The surface treatment apparatus as claimed in claim 8, **characterized in that** the material that assumes a liquid state at normal temperature and pressure is ejected into vacuum through a small opening, such that the clusters may be generated by adiabatic expansion.

10. The surface treatment apparatus as claimed in claim 9, **characterized in that** the small opening is provided in the shape of a nozzle.

11. The surface treatment apparatus as claimed in claim 8, **characterized in that** the cluster thus generated is ionized by electron impact.

12. The surface treatment apparatus as claimed in claim 8, **characterized in that** the number of the constituting molecules of the cluster ion beams is selected by mass separation based on retardation field method.

13. The surface treatment apparatus as claimed in claim 6, **characterized in that** the incident energy of the ions incident to the surface of the solid material is controlled.
